# EUROPÄISCHE PATENTSCHRIFT

(11) **EP 1 097 480 B1**
(45) Veröffentlichungstag und Bekanntmachung des Hinweises auf die Patenterteilung: **20.03.2002**
(21) Anmeldenummer: 99945920.9
(22) Anmeldetag: 05.07.1999
(51) Int. Cl.: H01L 29/00

(54) **LEISTUNGSHALBLEITERELEMENT MIT EINEM EMITTERBEREICH, DEM EINE STOPPZONE VORGELAGERT IST**
SEMI-CONDUCTOR ELEMENT WITH AN EMITTER AREA AND A STOP ZONE IN A PRE-MOUNTED POSITION THERETO
ELEMENT SEMI-CONDUCTEUR COMPRENANT UNE ZONE EMETTEUR ET UNE ZONE D'ARRET SOUS-JACENTE

(30) Priorität: 17.07.1998 DE 19832310
(43) Veröffentlichungstag der Anmeldung: 09.05.2001
(73) Patentinhaber: Infineon Technologies AG, 81669 München (DE)
(72) Erfinder: BAUER, Josef-Georg, D-85229 Markt Indersdorf (DE); BRUNNER, Heinrich, D-84405 Dorfen (DE); SCHULZE, Hans-Joachim, D-85521 Ottobrunn (DE)
(74) Vertreter: Viering, Jentschura & Partner
(86) Internationale Anmeldenummer: DE9902082
(87) Internationale Veröffentlichungsnummer: WO0004598

(56) Entgegenhaltungen:
- EP-A- 0 760 528
- DE-A- 3 917 769

## Beschreibung

Die Erfindung betrifft ein Leistungshalbleiterelement mit einem Emitterbereich, dem eine Stoppzone vorgelagert ist, wobei die Leitfähigkeiten des Emitterbereichs und der Stoppzone einander entgegengesetzt sind.

Bei asymmetrischen Thyristoren wird gegenüber symmetrischen Thyristoren eine Verringerung der Dicke des Bauelements dadurch erzielt, daß anodenseitig dem p-Emitter eine n- Stoppzone vorgelagert wird. Sie hat die Aufgabe, den Durchgriff des elektrischen Feldes auf den p-Emitter bei voller Sperrspannung zu verhindern. Damit ermöglicht die Sperrzone eine erhebliche Reduzierung der Gesamtverluste des Leistungshalbleiters, insbesondere wenn es sich um hochsperrende Bauelemente wie IGBTs oder Thyristoren handelt, die eine Sperrspannung von mehr als 3 kV zulassen und deren Dicke bei mehr als 500 µm liegt und damit relativ groß ist.

Je höher die Stoppzone vor einem anodenseitigen Emitter bei einem Thyristor dotiert wird, desto geringer wird der Teiltransistorverstärkungsfaktor αₚₙₚ. Damit steigt zwar einerseits die erzielbare Kippspannung des Thyristors, bei der der Übergang von der Blockierkennlinie zur Flußkennlinie erfolgt, andererseits steigt jedoch auch die Durchlaßspannung und damit die statische Verlustleistung. Die statischen und dynamischen Verluste des Thyristors sind also über die Eigenschaften der Stoppzone miteinander gekoppelt.

Aufgabe der Erfindung ist es, einen Leistungshalbleiter mit einer Stoppzone zu schaffen, bei dem sowohl die statischen als auch die dynamischen Verluste kleiner als bei Bauelementen nach dem Stand der Technik sind.

Die Aufgabe wird gelöst durch einen Leistungshalbleiter mit den Merkmalen nach Anspruch 1. Bevorzugte Ausführungsformen sind Gegenstand des Ünteranspruchs.

Der Erfindung liegt das Prinzip zugrunde, daß die Stoppzone nur im Sperrzustand des Bauelements "aktiv" zu sein braucht, nicht aber im Durchlaßbetrieb. Mit anderen Worten, die Anzahl der durch die Störstellen in der Stoppzone erzeugten, als Dotierstoff wirksamen Atome sollte sich in Abhängigkeit von der Betriebsart (Sperr- oder Durchlaßbetrieb) des Bauelements ändern. Dies wird dadurch erreicht, daß durch die Dotieratome Energieniveaus bereitgestellt werden, die innerhalb der Bandlücke des Halbleitermaterials weit entfernt von den Energieniveaus des Leitungsbandes und des Valenzbandes liegen.

Das erfindungsgemäße Leistungshalbleiterelement mit einem Emitterbereich, dem eine Stoppzone mit Fremdatomen vorgelagert ist, wobei die Leitfähigkeiten des Emitterbereichs und der Stoppzone einander entgegengesetzt sind, ist dadurch gekennzeichnet, daß die Fremdatome in der Stoppzone mindestens ein Energieniveau haben, das innerhalb der Bandlücke des Halbleiters liegt und von Leitungs- und Valenzband des Halbleiters mindestens 200 meV entfernt ist.

Insbesondere ist der Dotierstoff Schwefel oder Selen.

Ein Vorteil des Leistungshalbleiters mit einer mit Schwefel dotierten Stoppzone ist es, daß die Diffusionskonstante von Schwefelatomen sehr hoch ist und damit die Stoppzone auf einfache Art und Weise erzeugt werden kann.

EP-A-0760528 beschreibt ein Halbleiterbauelement mit hochsperrendem Randabschluß, wobei der Randabschluß mit einem Dotierstoff verunreinigt ist, der ein tiefes Störstellen-Energieniveau von wenigstens 100 meV (z. B. Selen oder Schwefel) aufweist.

Weitere Vorteile und Merkmale der Erfindung ergeben sich aus der folgenden Beschreibung bevorzugter Ausführungsformen der Erfindung, bei der bezug genommen wird auf die beigefügten Zeichnungen.

Fig. 1 zeigt eine Ausführungsform des erfindungsgemäßen Leistungshalbleiters mit einer anodenseitigen Stoppzone im Querschnitt.

Fig. 2 zeigt die Dotierstoffkonzentration des Bauelements nach Fig. 1.

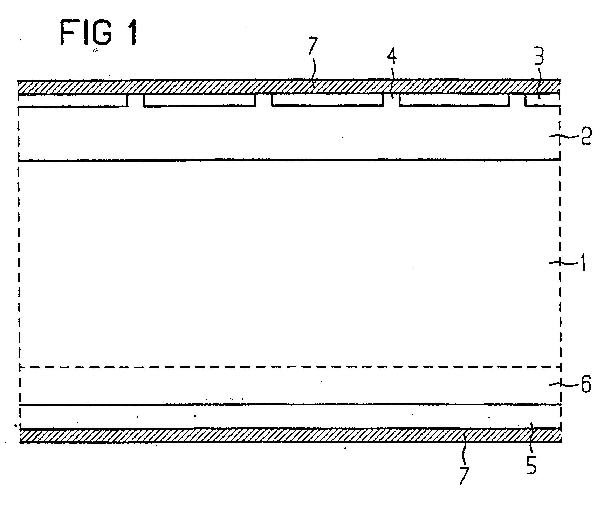

Als Leistungshalbleiterelement ist in Fig. 1 ein Thyristor dargestellt, der einen Halbleiter 1 umfaßt, der in der gezeigten Ausführungsform schwach n-dotiert ist und als n⁻ - Basis wirkt. An die n⁻-Basis 1 schließt sich eine p-Basis 2 an, auf deren Oberfläche eine kathodenseitige n⁺- Emitterstruktur 3 mit Kathodenkurzschlüssen 4 angeordnet ist.

Auf der der p-Basis 2 gegenüberliegenden Seite der n⁻-Basis 1 befindet sich ein anodenseitiger p-Emitter 5. Der p-Emitter 5 wird, wie im Stand der Technik bekannt, durch eine Stoppzone 6 gegen den Durchgriff des Feldes bei voller Sperrspannung abgeschirmt. Die Stoppzone 6 ist n-dotiert, d.h. als Dotierstoff wird im Stand der Technik insbesondere Phosphor oder Arsen verwendet.

Beide Emitter 3 und 5 werden über Metallisierungen 7 elektrisch mit einem externen Anoden- bzw. Kathodenanschluß verbunden.

Erfindungsgemäß wird die Stoppzone 6 mit einem Dotierstoff dotiert, dessen Energieniveaus in der Bandlücke weit, d.h. mindestens 200 meV von dem Valenz- bzw. Leitungsband entfernt liegen. Als hierfür geeigneter Dotierstoff kommen insbesondere neben anderen Atomen Schwefelatome in Frage, da diese bei Zimmertemperatur nur zum Teil elektrisch aktiv sind. Wird der schwefeldotierte Bereich jedoch von einer Raumladungszone erfaßt, werden diese Schwefelatome vollständig als Doppeldonatoren aktiv, d.h. Donatoren mit zwei freigesetzten Ladungsträgern, so daß ein Schwefelatom zweifach geladen ist. Die Energieniveaus von Schwefel liegen so tief in der Siliziumbandlücke, daß sie erst bei Anlegen einer Raumladungszone vollständig elektrisch aktiviert werden: Ein Energieniveau von Schwefel liegt 260 meV unterhalb des Leitungsbandes in Silizium, und ein zweites Energieniveau liegt bei 480 meV oberhalb des Valenzbandes. Die Bandlücke von Silizium beträgt 1120 meV. D.h. also, daß einerseits die Stoppzone im Durchlaßzustand nur teilweise elektrisch aktiv ist, somit der Teiltransistorverstärkungsfaktor αₚₙₚ nur relativ gering abgesenkt wird und die Durchlaßspannung dadurch gering gehalten werden kann. Andererseits wird der von der Raumladungszone erfaßte Teil der Stoppzone im Sperrzustand vollständig aktiviert, was somit eine sehr effektive Stoppzone zur Folge hat. Die Korrelation zwischen Durchlaßspannung und Sperrspannung wird somit also verbessert.

Eine weitere Ausführungsform des erfindungsgemäßen Leistungshalbleiterelements hat als Dotierstoff Selen, das in Si innerhalb der Bandlücke zwei Energieniveaus hat, die etwa 310 meV bzw. 590 meV unterhalb des Leitungsbandes liegen.

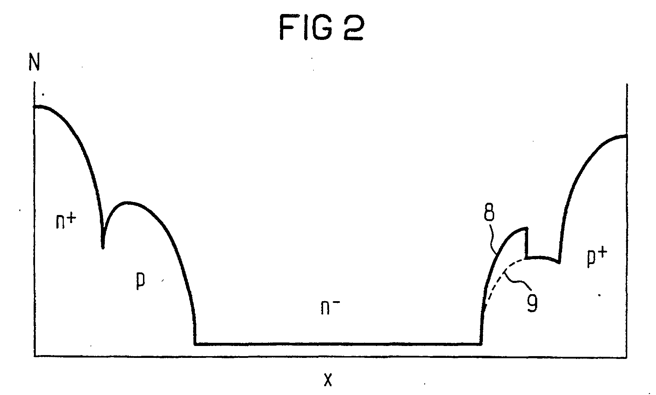

Das Dotierprofil des Bauelements nach Fig. 1 ist in Fig. 2 dargestellt. Der kathodenseitige Emitter 3, der ganz links in der Fig. 2 dargestellt ist, ist n⁺-dotiert. Daran schließt sich in der folgenden Reihenfolge die p-Basis 2, die n⁻-Basis 1, die Stoppzone 6 und der p-Emitter 5 an. In der Stoppzone 6, die durch die Dotierstoffatome erzeugt wird, sind zwei Dotierverläufe gezeigt, die mit 8 bzw. 9 bezeichnet sind, wobei 9 gestrichelt dargestellt ist. Während der Dotierverlauf 8 der Stoppzone 6 im Sperrzustand in dem Bereich der Raumladungszone einen Verlauf nimmt, der von der n⁻-Basis 1 aus gesehen steil ansteigt und damit einen Durchgriff des Feldes auf den p-Emitter 5 verhindert, ist der Verlauf des Dotierprofils 9 der Stoppzone 6 im Durchlaßzustand abgeflacht, d.h. die Ladungsträger gelangen aus der n⁻-Basis 1 zu dem p-Emitter 5 bzw. umgekehrt, wobei sie eine deutlich schwächere Stoppzone 6 "wahrnehmen".

Beim Herstellen eines Leistungshalbleiters wird eine Stoppzone vor dem Emitterbereich z.B. durch anodenseitiges Implantieren von Fremdatomen erzeugt. Nach dem Implantieren von Fremdatomen wie Phosphor oder Arsen werden die Fremdatome oder Dotieratome zur Erzeugung der n-dotierten Stoppzone 6 in die Siliziumscheibe eindiffundiert und das Kristallgitter ausgeheilt. Dazu wird der Halbleiter einem Temperaturbehandlungsschritt unterworfen. Die Höhe der Temperatur und die Dauer der Behandlung hängen von den Eigenschaften der Dotieratome und des Halbleitermaterials ab. Wegen der niedrigen Diffusionskonstante von Phosphor und Arsen in Silizium müssen im Temperaturbehandlungsschritt nach der Implantation relativ hohe Diffusionstemperaturen und lange Diffusionszeiten gewählt werden, nämlich Temperaturen, die oberhalb von 1200°C liegen, und Diffusionszeiten von typischerweise über 20 Stunden.

Ein Vorteil von Schwefel als Dotierstoff für die Erzeugung der Stoppzone 6 ist es, daß es in Silizium relativ schnell diffundiert. Damit lassen sich Diffusionszeit und Temperatur deutlich reduzieren. Das Einbringen der Schwefelatome kann z.B. durch eine anodenseitige Ionenimplantation mit einem nachfolgenden Eintreibschritt erfolgen. Als typische Implantationsdosis kommt eine Dosis zwischen 10¹² und 10¹⁴ Schwefelatomen pro cm² in Frage. So bringt gegenüber Phosphor als Dotierstoff Schwefel eine Absenkung der Spannung im Durchlaßbetrieb von etwa 10% bei einer Dosis von etwa 5 × 10¹² Schwefelatomen pro cm².

Die Erfindung wurde anhand eines Thyristors als Leistungshalbleiter beschrieben. Es ist für den Fachmann jedoch selbstverständlich, daß die offenbarte technische Lehre auch auf andere Leistungsbauelemente wie IGBTs o.ä. angewendet werden kann.

## Patentansprüche

1. Leistungshalbleiterelement mit einem Emitterbereich (5), dem eine Stoppzone (6) mit Fremdatomen vorgelagert ist, wobei die Leitfähigkeiten des Emitterbereichs (5) und der Stoppzone (6) einander entgegengesetzt sind,
**dadurch gekennzeichnet, daß**
die Fremdatome in der Stoppzone (6) mindestens ein Energieniveau haben, das innerhalb der Bandlücke des Halbleiters liegt und von Leitungs- und Valenzband des Halbleiters mindestens 200 meV entfernt ist.

2. Leistungshalbleiterelement nach Anspruch 1,
**dadurch gekennzeichnet, daß**
die Fremdatome in der Stoppzone (6) Schwefelatome umfassen.

3. Leistungshalbleiterelement nach Anspruch 1,
**dadurch gekennzeichnet, daß**
die Fremdatome in der Stoppzone (6) Selenatome umfassen.

## Claims

1. Power semiconductor element having an emitter region (5) preceded by a stop zone (6) with impurity atoms, the emitter region (5) and the stop zone (6) having mutually opposite conductivities:
**characterized in that**
the impurity atoms in the stop zone (6) have at least one energy level which lies within the band gap of the semiconductor and is at least 200 meV away from the conduction and valence band of the semiconductor.

2. Power semiconductor element according to Claim 1,
**characterized in that**
the impurity atoms in the stop zone (6) comprise sulphur atoms.

3. Power semiconductor element according to Claim 1,
**characterized in that**
the impurity atoms in the stop zone (6) comprise selenium atoms.

## Revendications

1. Elément semi-conducteur de puissance comprenant une zone d'émetteur (5) en aval d'une zone d'arrêt (6) avec des atomes étrangers, les conductivités de la zone d'émetteur (5) et de la zone d'arrêt (6) étant inversées l'une par rapport à l'autre, **caractérisé en ce que** les atomes étrangers dans la zone d'arrêt (6) présentent au moins un niveau d'énergie qui se situe dans l'écart énergétique du semi-conducteur et qui est distant des bandes de conduction et de valence du semi-conducteur d'au moins 200 meV.

2. Elément semi-conducteur de puissance selon la revendication 1, **caractérisé en ce que** les atomes étrangers dans la zone d'arrêt (6) comprennent des atomes de soufre.

3. Elément semi-conducteur de puissance selon la revendication 1, **caractérisé en ce que** les atomes étrangers dans la zone d'arrêt (6) comprennent des atomes de sélénium.
